# EUROPEAN PATENT APPLICATION

(11) **EP 3 006 909 A1**
(43) Date of publication of application: **13.04.2016**
(21) Application number: 14808457.7
(22) Date of filing: 14.05.2014
(51) Int. Cl.: G01H 17/00

(54) **VIBRATION DETECTOR**

(30) Priority: 04.06.2013 JP 2013117752; 23.10.2013 JP 2013220113
(71) Applicant: Denso Corporation, Kariya-shi, Aichi 448-8661 (JP)
(72) Inventor: YAZAKI, Yoshitaro, Kariya-city, Aichi 448-8661 (JP); SHIRAISHI, Yoshihiko, Kariya-city, Aichi 448-8661 (JP); TANAKA, Yasuhiro, Kariya-city, Aichi 448-8661 (JP); HARADA, Toshikazu, Kariya-city, Aichi 448-8661 (JP); SHIMIZU, Motoki, Kariya-city, Aichi 448-8661 (JP); SAKAIDA, Atusi, Kariya-city, Aichi 448-8661 (JP); TANIGUCHI, Toshihisa, Kariya-city, Aichi 448-8661 (JP); GOUKO, Norio, Kariya-city, Aichi 448-8661 (JP); SAITOU, Keita, Kariya-city, Aichi 448-8661 (JP)
(74) Representative: Kuhnen & Wacker
(86) International application number: PCT/JP2014/062876
(87) International publication number: WO 2014/196327

(57) **Abstract**

A vibration detector has a structure including a heat generation member which generates heat when subjected to at least one of deformation and friction by external vibration and a detection element for detecting a heat flux from the heat generation member, and configured to detect data regarding vibration based on a detection result of the detection element. The detection element has a structure in which an insulation base material 100 made of thermoplastic resin is formed with first and second via holes 101 and 102 penetrating therethrough in a thickness direction, first and second inter-layer connection members formed of different metals are embedded in the first and second via holes, and the first and second inter-layer connection members are connected in series alternately, the metals forming the first and second inter-layer connection members being sintered alloys sintered in a state in which metal atoms maintain a crystal structure thereof.

## Description

### Technical Field

The present invention relates to a vibration detector that uses a heat flux sensor.

### Background Art

As a heat flux sensor (detection element) for detecting a heat flux, there is one described in Patent Literature 1. This detection element is such that a plurality of through holes are formed in an insulation base material with first and second conductive metals of dissimilar metal materials being embedded in the plurality of the through holes, and the first and second conductive metals being connected in series alternately.

### Citation List

### Patent Literature

PTL1: Japanese Patent Application Laid-open 2009-192431

### Summary of Invention

### Technical Problem

Incidentally, when a vibration is applied from the outside, deformation or friction occurs depending on other members, causing a heat flux to occur from this member. Accordingly, if the sensitivity of the heat flux sensor (detection element) is high, it is possible to detect the heat flux occurring when applied with a vibration, and to obtain data regarding the vibration from this detection result.

However, in a case where the insulation base material is made of a hard material and the detection element does not have flexibility, since the detection element can be installed only at places which coincide with the shape of the detection element, there is a problem that places at which the detection element is installed are limited. For example, if the detection element has a planar shape, the detection element can be installed at places having a planar surface, but cannot be installed at places having a curved surface or an uneven surface.

To cope with this problem, it may occur that the detection element is manufactured to have a shape corresponding to a shape of an installation space. However, in this case, since it is not possible to manufacture the detection elements in a single uniform way, it is unfavorable in terms of the manufacturing cost of the detection element.

In view of the above, the present invention aims to provide a vibration detector whose detection element can be installed regardless of the shapes of installing places.

### Solution to Problem

To attain the aim, the invention described in claim 1 comprises:
a detection element having a structure in which an insulation base material (100) is formed with first and second via holes (101, 102) penetrating therethrough in a thickness direction, first and second inter-layer connection members (130, 140) formed of different metals are embedded in the first and second via holes, and the first and second inter-layer connection members are connected in series alternately;
a heat generation member (30, 110) disposed on one surface of the detection element;
a protection member (120) disposed on the other surface of the detection element; wherein
at least one of the metals forming the first and second inter-layer connection members is a sintered alloy sintered in a state in which metal atoms maintain a crystal structure thereof,
the heat generation member generates heat when subjected to at least one of deformation and friction by external vibration,
the detection element detects a heat flux between the heat generation member and the protection member by an electromotive force occurring in the first and second inter-layer connection members which are series-connected alternately, and
the invention further comprises a detection processing means (2) which performs a detection process of data regarding vibration based on the electromotive force occurring in the detection element.

### Advantageous Effects of Invention

In the present invention, since the insulation base material of the detection element is made of thermoplastic resin, the detection element has flexibility. Accordingly, the detection element can be installed by being deformed to a shape in accordance with a shape of an installing place. Therefore, according to the present invention, the detection element can be installed regardless of shapes of installing places.

Further, the heat generation member deforms by vibration and generates heat, or generates heat by friction when applied with a vibration from the outside. At this time, a heat flux from the heat generation member increases or decreases in accordance with the magnitude of a vibration energy applied. Therefore, according to the present invention in which the heat flux of the heat generation member is detected and the detection process is performed based on this detection result, data regarding the vibration can be obtained.

Incidentally, in the present invention, there is used the heat flux sensor in which at least one of the metals forming the first and second inter-layer connection members is a sintered alloy sintered in a state in which metal atoms maintain a crystal structure thereof. This makes it possible to increase the electromotive force occurring in the first and second inter-layer connection members to thereby increase the sensitivity of the heat flux sensor. As described above, according to the present invention that uses the highly sensitive heat flux sensor, it is possible to obtain data regarding vibration.

Incidentally, the reference signs in parentheses of the respective means described in this section and Claims show examples of relationships with specific means described in the embodiments described later.

### Brief Description of Drawings

[Fig. 1] is a schematic diagram showing the structure of a vibration detector according to a first embodiment.
[Fig. 2] is a plan view of a heat flux sensor in Fig. 1.
[Fig. 3] is a cross-sectional view of Fig. 2 taken along line III-III.
[Fig. 4] is a cross-sectional view of Fig. 2 taken along line IV-IV.
[Fig. 5] is a cross-sectional view showing a manufacturing process of the heat flux sensor.
[Fig. 6] is a flowchart of a control process performed by a control section in the first embodiment.
[Fig. 7A] is a cross-sectional view of a vibration detecting section in a second embodiment.
[Fig. 7B] is a cross-sectional view showing a vibration state of a vibration detecting section of Fig. 7A.
[Fig. 8A] is a cross-sectional view of a vibration detecting section in a third embodiment.
[Fig. 8B] is a cross-sectional view showing a vibration state of a vibration detecting section of Fig. 8A.
[Fig. 9] is a flowchart of a control process performed by a control section in another embodiment.
[Fig. 10] is a schematic diagram showing the structure of a pressure detector in a reference example.
[Fig. 11] is a schematic diagram showing the structure of a humidity detector in a reference example.

### Description of Embodiments

Embodiments of the present invention are explained below with reference to the drawings. Parts which are the same or equivalent to each other are followed by the same reference sign to explain them in the following embodiments.

### (First Embodiment)

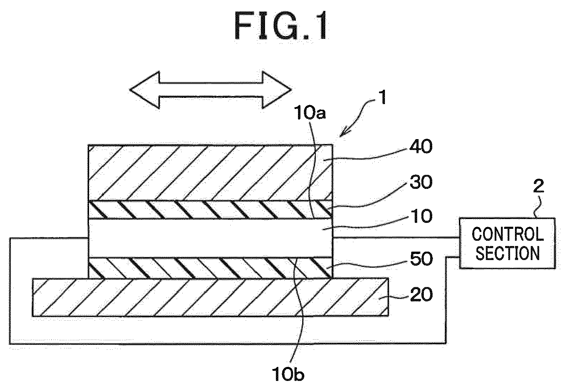

As shown in Fig. 1, a vibration detector of this embodiment includes a vibration detecting section 1 and a control section 2. The vibration detecting section 1 includes a heat flux sensor 10, a fixing base 20 which is disposed on the back side 10b of the heat flux sensor 10, and a rubber 30 and a weight 40 which are disposed on the front side 10a of the heat flux sensor.

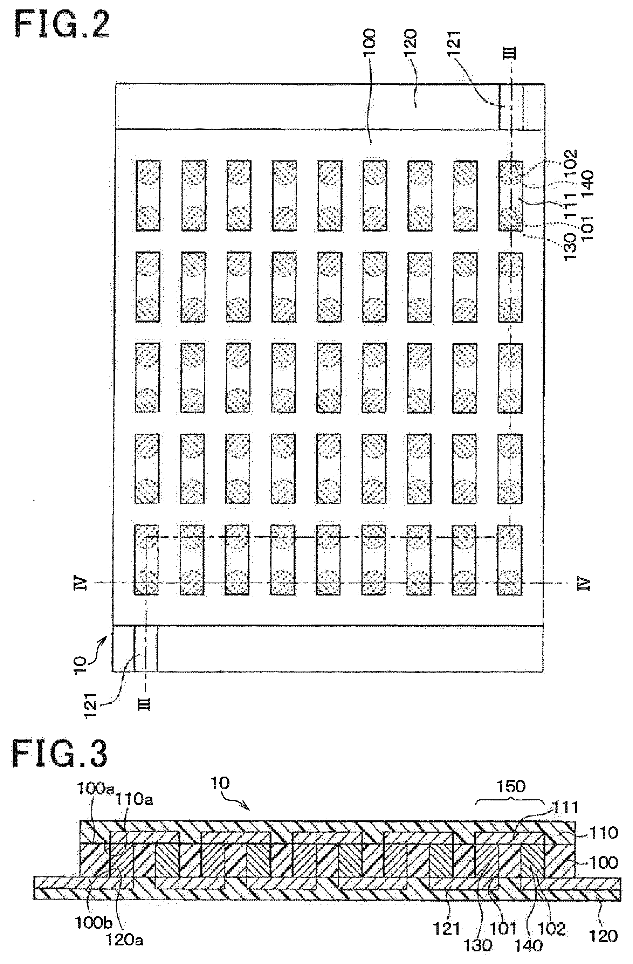

As shown in Figs. 2 to 4, the heat flux sensor 10 is such that an insulation base material 100, a front surface protection member 110, a back surface protection member 120 are integrated, first and second inter-layer connection members 130 and 140 being connected in series alternately therein. The structure of the heat flux sensor 10 is explained specifically in the following. Incidentally, the front surface protection member 110 is omitted from Fig. 2 to assist understanding.

In this embodiment, the insulation base material 100 is formed of a thermoplastic resin film of a planar rectangular shape typified by polyetheretherketone (PEEK), polyetherimide (PEI), liquid crystal polymer (LCP) and so on. A plurality of first and second via holes 101 and 102 penetrating in the thickness direction are formed in a staggered pattern so as to alternate with each other.

Although the first and second via holes 101 and 102 of this embodiment are made to have a cylindrical shape whose diameter is constant from the front surface 100a to the back surface 100b, they may be made to have a tapered shape in which the diameter decreases from the front surface 100a to the back surface 100b. Further, they may be made to have a tapered shape in which the diameter decreases from the back surface 100b to the front surface 100a.

The first inter-layer connection member 130 is disposed in the first via hole 101, and the second inter-layer connection member 140 is disposed in the second via hole 102. That is, the first and the second inter-layer connection members 130 and 140 are disposed in the insulation base material 100 so as to alternate with each other.

The first and second inter-layer connection members 130 and 140 are made of metals different from each other so as to exhibit the Seebeck effect. For example, the first inter-layer connection member 130 is formed of a metal compound in which a powder of a P-type Bi-Sb-Te alloy is solid-phase sintered so as to maintain the crystal structure of the metal atoms as it was before the sintering. Likewise, the second inter-layer connection member 140 is formed of a metal compound in which a powder of an N-type Bi-Te alloy is solid-phase sintered so as to maintain the crystal structure of the metal atoms as it was before the sintering.

Incidentally, although Fig. 2 is not a cross-sectional view, the first and second inter-layer connection members 130 and 140 are hatched for ease of understanding.

On the front surface 100a of the insulation base material 100, there is disposed the front surface protection member 110 formed of a thermoplastic resin film of a planar rectangular shape, which is typified by polyetheretherketone (PEEK), polyetherimide (PEI), and liquid crystal polymer (LCP). This front surface protection member 100a is the same in planar shape size as the insulation base material 100, and is formed with a plurality of front surface patterns 111 in which copper foils or the like are patterned so as to be mutually separated from one another on one surface 110a facing the insulation base material 100. Each of the front surface patterns 111 is electrically connected to the first and second inter-layer connection members 130 and 140 suitably.

Specifically, as shown in Fig. 3, when one of the first inter-layer connection members 130 and one of the second inter-layer connection members 140 which are adjacent to each other are referred to as a pair 150, the first and second inter-layer connection members 130 and 140 of each pair 150 are connected to the same front surface pattern 111. That is, the first and second inter-layer connection members 130 and 140 of each pair 150 are electrically connected to each other through the front surface pattern 111. Incidentally, in this embodiment, one first inter-layer connection member 130 and one second inter-layer connection member 140 which are adjacent to each other in the longitudinal direction of the insulation base material (the left-right direction in Fig. 3) constitutes the pair 150.

On the back surface 100b of the insulation base material 100, there is disposed the back surface protection member 120 formed of a thermoplastic resin film of a planar rectangular shape, which is typified by polyetheretherketone (PEEK), polyetherimide (PEI), and liquid crystal polymer (LCP). This back surface protection member 120 is larger in the length in the longitudinal direction than the insulation base material 100, and is disposed on the back surface 100b of the insulation base material 100 such that its both ends in the longitudinal direction project from the insulation base material 100.

The back surface protection member 120 is formed with a plurality of back surface patterns 121 in which copper foils or the like are patterned so as to be mutually separated from one another on one surface 120a facing the insulation base material 100. Each of the back surface patterns 121 is electrically connected to the first and second inter-layer connection members 130 and 140 suitably.

Specifically, as shown in Fig. 3, the first inter-layer connection member 130 of one of the pairs 150 which are adjacent to each other in the longitudinal direction of the insulation base material 100 and the second inter-layer connection member 140 of the other one of pairs 150 are connected to the same back surface pattern 121. That is, the first and second inter-layer connection members 130 and 140 are electrically connected to each other through the same back surface pattern 121 across the pair 150.

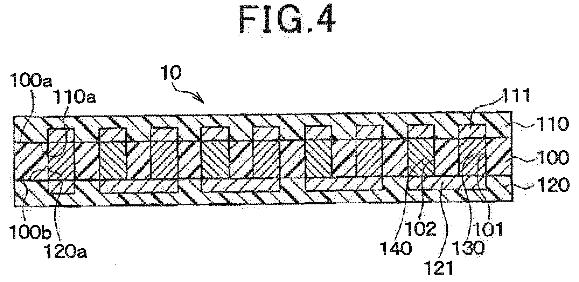

Further, as shown in Fig. 4, the first and second inter-layer connection members 130 and 140 which are adjacent to each other in the direction (the up-down direction in Fig. 2) perpendicular to the longitudinal direction are connected to the same back surface pattern 121 at the outer edge of the insulation base material 100. In more detail, the adjacent first and second inter-layer connection members 130 and 140 are connected to the same back surface pattern 121 such that the ones which are series-connected to each other in the longitudinal direction of the insulation base material 100 through the front surface pattern 111 and the back surface pattern 121 are folded back.

As shown in Figs. 2 and 3, an end part of the back surface patterns 121 that are series-connected as described above is formed to be exposed from the insulation base material 100. The part exposed from the insulation base material 100 of the back surface patterns 121 serves as a terminal to be connected to the control section 2.

The above is the basic structure of the heat flux sensor 10 according to this embodiment. Such a heat flux sensor 10 outputs a sensor signal (electromotive voltage) in accordance with a heat flux passing the heat flux sensor 10 in the thickness direction to the control section 2. When the heat flux changes, the electromotive voltage occurring in the first and second inter-layer connection members 130 and 140 which are series-connected alternately changes. Incidentally, the thickness direction of the heat flux sensor 10 is the lamination direction of the insulation base material 100, the front surface protection member 110 and the back surface protection member 120. The structural part of the heat flux sensor 10, in which the first and second inter-layer connection members 130 and 140 are series-connected alternately, forms a detection element for detecting the heat flux.

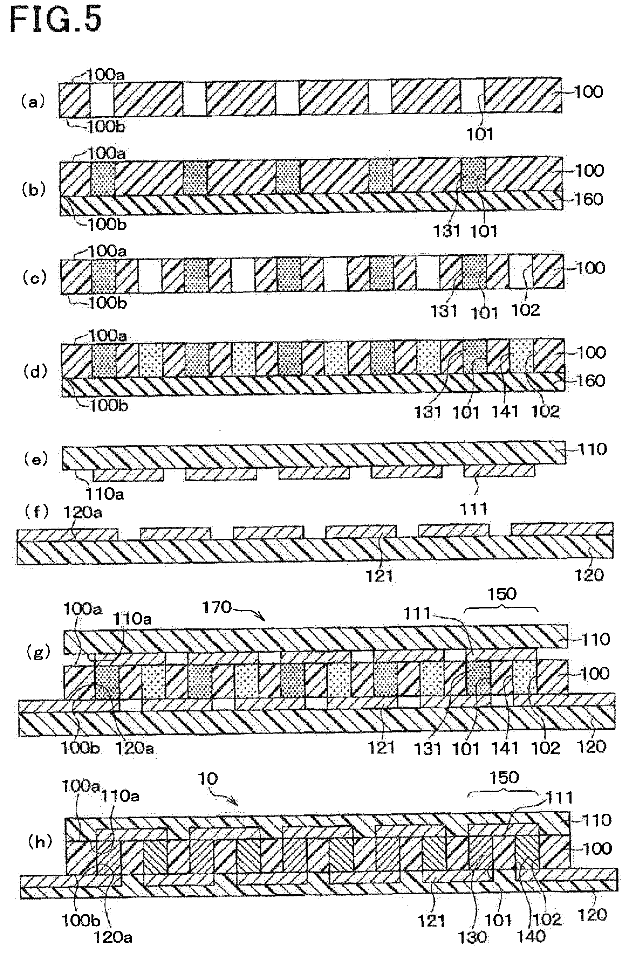

Here, a method of manufacturing the above described heat flux sensor 10 is explained with reference to Fig. 5.

First, as shown in Fig. 5(a), the insulation base material 100 is prepared, and formed with the first via holes 101 by a drill, laser or the like.

Next, as shown in Fig. 5(b), a first conductive paste 131 is filled in each of the first via holes 101. Incidentally, for a method (apparatus) for filling the first conductive paste 131 in the first via holes 101, the method (apparatus) described in Japanese Patent Application No. 2010-50356 by the applicant of this application can be used.

To explain it briefly, the insulation base material 100 is placed on a not-shown holding base through adsorption paper 160 such that the back surface 100b faces the adsorption paper 160. Then, the first conductive paste 131 is filled in the first via holes 101, while melting the first conductive paste 131. As a result, most part of the organic solvent of the first conductive paste 131 is adsorbed by the adsorption paper 160, and the powder of the alloy is filled densely in the first via holes 101.

As the adsorption paper 160 which should be made of material capable of adsorbing the organic solvent of the first conductive paste 131, general high-quality paper or the like is used. As the first conductive paste 131, there is used a powder of a Bi-Sb-Te alloy whose metal atoms maintain a certain crystal structure, which is mixed with an organic solvent having a melting point of 43 degrees C such as paraffin to become pasty. Accordingly, the first conductive paste 131 is filled in a state in which the front surface 100a of the insulation base material 100 is heated at the temperature of approximately 43 degrees C.

Subsequently, as shown in Fig. 5(c), the insulation base material 100 is formed with the second via holes 102 by a drill, laser or the like. The second via holes 102 are formed in a staggered pattern with the first via holes 101 so as to alternate with the first via holes 101 as described in the foregoing.

Next, as shown in Fig. 5(d), a second conductive paste 141 is filled in the respective second via holes 102. This process can be performed similarly to the process of Fig. 5(b).

That is, after the insulation base material 100 is placed again on the not-shown holding base through the adsorption paper 160 such that the back surface 100b faces the adsorption paper 160, the second conductive paste 141 is filled in the respective second via holes 102. As a result, most of the organic solvent of the second conductive paste 141 is adsorbed by the adsorption paper 160, and the powder of the alloy is filled densely in the second via holes 102.

As the second conductive paste 141, there is used a powder of a Bi-Te alloy whose metal atoms are different from the metal atoms constituting the first conductive paste 131 which maintain a certain crystal structure, the Bi-Te alloy being mixed with an organic solvent having a melting point of room temperature such as turpentine to become pasty. That is, the melting point of the organic solvent constituting the second conductive paste 141 is lower than the melting point of the organic solvent constituting the first conductive paste 131. The second conductive paste 141 is filled in a state in which the front surface 100a of the insulation base material 100 is maintained at the normal temperature. In other words, the second conductive paste 141 is filled in a state where the organic solvent contained in the first conductive paste 131 is solidified. This makes it possible to prevent the second conductive paste 141 from entering the first via holes 101.

The state in which the organic solvent contained in the first conductive paste 131 is solidified is a state in which the organic solvent remains in the first via holes 101 without being adsorbed in the adsorption paper 160 in the process of Fig. 5(b).

In a process different from the above described respective processes, copper foils or the like are formed on the surfaces 110a and 120a of the front surface protection member 110 and the back surface protection member 120, which face the insulation base material 100 as shown in Figs. 5(e) and 5(f). The front surface protection member 110 formed with the front surface patterns 111 which are separated from one another and the back surface protection member 120 formed with the back surface patterns 111 which are separated from one another are prepared by patterning these copper foils appropriately.

Thereafter, as shown in Fig. 5(g), the back surface protection member 120, the insulation base material 100 and the front surface protection member 110 are laminated in this order to form a laminated body 170.

In this embodiment, the length in the longitudinal direction of the back surface protection member 120 is larger than the insulation base material 100. The back surface protection member 120 is disposed such that the both ends in the longitudinal direction project from the insulation base material 100.

Subsequently, as shown in Fig. 5 (h), this laminated body 170 is disposed between a not shown pair of pressing plates, and pressed from both the top and bottom surfaces in the lamination direction while being heated in a vacuum state to integrate the laminated body 170. Specifically, the laminated body 170 is integrated while being heated such that the first and second conductive plates 131 and 142 are solid-phase sintered to form the first and second inter-layer connection members 130 and 140, and the first and second inter-layer connection members 130 and 140 are connected to the front surface patterns 111 and the back surface patterns 121.

Incidentally, a cushioning member such as wool paper may be disposed between the laminated body 170 and the pressing plates at the time of integrating the laminated body 170, although it is optional. In the above way, the heat flux sensor 10 is manufactured.

The fixing base 20 for the vibration detector 1 shown in Fig. 1, which is a fixing member for fixing the heat flux sensor 10, is joined to the back surface 10b of the heat flux sensor 10 through an adhesive 50. The surface of the fixing base 20 has a planar shape. Accordingly, the back surface 10b and the front surface 10a of the heat flux sensor 10 also have a planar shape.

The rubber 30 as an elastic member which elastically deforms is joined to the front surface 10a of the heat flux sensor 10 by an adhesive or the like. Examples of the material of the rubber 30 include nitrile rubber, acrylic rubber, silicon rubber, urethane rubber and so on. The weight 40 as a vibration member which vibrates when applied with a vibration from the outside is joined to the surface of the rubber 30 by an adhesive or the like.

The control section 2 is a detection processing means for performing a detection process of data regarding vibration based on a detection result of the heat flux sensor 10. The control section 2, which is an electronic control unit constituted of a microcomputer, a memory as storage means and its peripheral circuits, controls a not shown display section by performing a predetermined arithmetic process in accordance with a predetermined program.

Here, detection of data regarding vibration by the vibration detector of this embodiment is explained.

When vibration parallel to the surface direction of the heat flux sensor 10 is applied to the vibration detecting section 1 from the outside as shown by the arrow in Fig. 1, the weight 40 on the front surface 10a of the heat flux sensor 10 vibrates, and also the rubber 30 and the front surface protection member 110 vibrate. At this time, the rubber 30 and the front surface protection member 110 deform due to the vibration and generate heat by the deformation. That is, the rubber 30 and the front surface protection member 110 deform by being applied with a vibration from the outside, and emit heat by transforming the deformation energy into thermal energy. Accordingly, in this embodiment, the rubber 30 and the front surface protection member 110 constitute a heat generation member which generates heat when subjected to deformation by the vibration from the outside. On the other hand, the fixing base 20 on the side of the back surface 10b of the heat flux sensor 10 does not generate heat because it does not vibrate, or is suppressed from generating heat because it is suppressed from vibrating.

Therefore, when a vibration is applied to the vibration detector 1 from the outside, the temperature difference between the rubber 30 and the front surface protection member 110 on the side of the back surface 10a of the heat flux sensor 10 and the fixing base 20 on the side of the back surface 10b of the heat flux sensor 10 changes from that before the vibration is applied. That is, there occurs change in the heat flux in the direction from the rubber 30 and the front surface protection member 110 toward the fixing base 20 when there occurs a change from the vibration applied state to the vibration non-applied state. At this time, there is a relationship that the heat flux from the rubber 30 and the front surface protection member 110 increases or decreases in accordance with the magnitude of the vibration applied. Accordingly, by detecting the heat flux from the rubber 30 and the front surface protection member 110, the vibration energy can be calculated based on this detected heat flux and the relationship between the vibration energy and the heat flux.

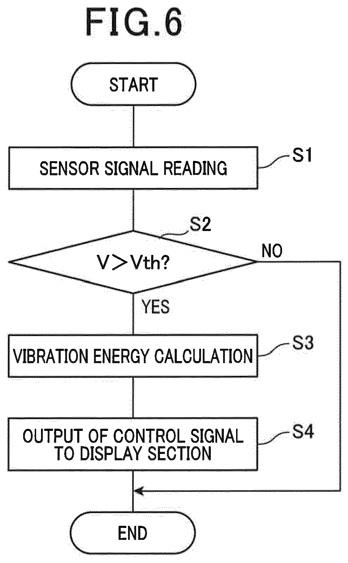

Hence, the control section 2 performs, as a detection process of data regarding vibration, a control process shown in Fig. 6. This control process is performed repeatedly at a predetermined time interval while the power supply switch of the vibration detector is on. Incidentally, the respective control steps in Fig. 6 constitute various function implementation means of the control section 2.

First, in step S1, the sensor signal inputted from the heat flux sensor 10 is read. That is, the electromotive voltage (voltage value) occurring in the heat flux sensor 10 is read.

Subsequently, it is determined whether or not the electromotive voltage V is larger than a threshold value Vth in step S2 . This is for discriminating between a minute electromotive voltage (noise) that has occurred by a temperature change of the installation environment of the heat flux sensor 10 or the like and the electromotive voltage that has occurred by a vibration. The threshold value Vth is set to be able to discriminate between the electromotive voltage that has occurred by vibration and noise. Accordingly, when a vibration is applied to the voltage detector 1, since the electromotive voltage V occurring in the heat flux sensor 10 is higher than the threshold value Vth, the control section 2 makes an affirmative determination (YES), and proceeds to step S3.

In step S3, the vibration energy is calculated based on the electromotive voltage V. A correlation between the electromotive voltage and the vibration energy was obtained beforehand. By using this correlation, the vibration energy can be calculated from the electromotive voltage V.

Subsequently, in step S4, a control signal for indicating the calculated vibration energy is outputted to the not shown display section. As a result, the vibration energy is indicated in the display section.

On the other hand, when no vibration is applied to the vibration detector 1, since the electromotive voltage occurring in the heat flux sensor 10 is lower than the threshold value, the control section 2 makes a negative determination (NO) in step S2, and the series of the control flow shown in Fig. 6 is ended without performing steps S3 and S4. Incidentally, a control signal to indicate the calculated value to be zero may be outputted to the display section when the negative determination is made in step S2.

In this way, the vibration detector of this embodiment can indicate the vibration energy in the display section when a vibration is inputted to the vibration detecting section.

In this embodiment, the rubber 30 is joined to the front surface 10a of the heat flux sensor 10, and the weight 40 is joined the surface of the rubber 30, however, they may not be joined. In this case, since the weight 40 vibrates causing friction to occur between the weight 40 and the rubber 30 or between the rubber 30 and the heat flux sensor 10, heat occurs. Accordingly, in this case, the friction heat can be contributed to a heat flux change when a vibration occurs. In this case, the rubber 30 constitutes a heat generation member which generates heat when subjected to deformation and friction by a vibration from the outside.

In this embodiment, although the rubber 30 and the weight 40 are provided on the front surface 10a of the heat flux sensor 10, they may be omitted. In this case, when a vibration is applied from the outside, since the front surface protection member 110 of the heat flux sensor 10 vibrates, the front surface protection member 110 deforms by the vibration causing heat to occur. Accordingly, since a change occurs in the heat flux from the front surface protection member 110 when there occurs a change from the vibration non-applied state to the vibration applied state, it is possible to calculate the vibration energy from the sensor signal of the heat flux sensor 10 also in this case. In this case, the front surface protection member 110 constitutes a heat generation member which generates heat when subjected to deformation by external vibration.

As explained above, in this embodiment, since the insulation base material 100, the front surface protection member 110 and the back surface protection member 120 are formed of thermoplastic resin, the heat flux sensor 10 has flexibility. Accordingly, the heat flux sensor 10 can be installed by being deformed to a shape in accordance with a shape of an installing place. In this embodiment, the surface of the fixing base 20 has a planar shape, however, even if the surface of the fixing base 20 has an uneven shape, the heat flux sensor 10 can be installed by being deformed.

The heat flux sensor 10 of this embodiment is constituted by forming the first and second vial holes 101 and 102 in the insulation base material 100 made of thermoplastic resin, and disposing the first and second inter-layer connection members 130 and 140 in the first and second via holes 101 and 102. Accordingly, the first and second inter-layer connection members 130 and 140 can be densified by changing the number, the diameter, the interval and so on of the first and second via holes 101 and 102. As a result, the sensitivity of the heat flux sensor 10 can be increased.

The heat flux sensor 10 of this embodiment uses, as the first and second inter-layer connection members 130 and 140, the metal compound (Bi-Sb-Te alloy, Bi-Te alloy) solid-phase sintered so as to maintain the crystal structure of the metal atoms as it was before the sintering. That is, the metal which forms the first or second inter-layer connection members 130 and 140 is a sintered alloy sintered in a state in which the metal atoms maintain the crystal structure thereof. This makes it possible to increase the electromotive voltage which occurs in the first and second inter-layer connection members 130 and 140 which are series-connected alternately.

In this way, according to this embodiment, since the highly sensitive heat flux sensor 10 is used, it is possible to detect a heat flux which occurs when a vibration is applied to the member, and to obtain data regarding the vibration from this detection result.

### (Second Embodiment)

In the first embodiment, the heat flux sensor 10 is fitted to a flat surface, while in this embodiment, the heat flux sensor 10 is fitted to a curved surface.

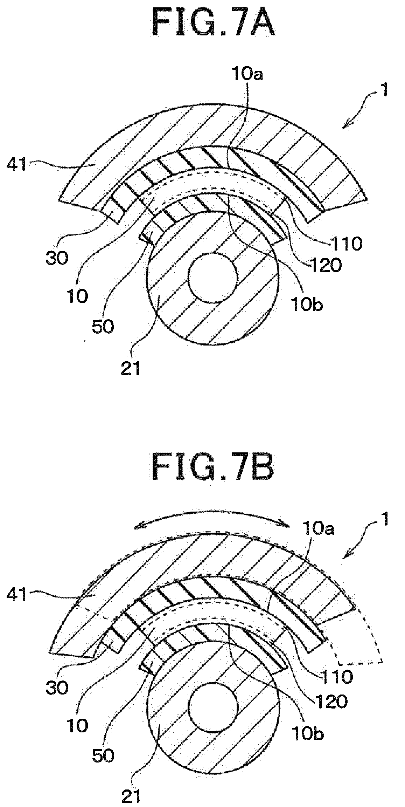

As shown in Fig. 7A, the vibration detecting section 1 of this embodiment is joined to the surface (curved surface) of a rotation shaft 21 through an adhesive 50 at the back surface 10b of the heat flux sensor 10. Accordingly, the heat flux sensor 10 is formed in a curved shape. Since the heat flux sensor10 which is the same as that of the first embodiment has flexibility, it can be fitted to a curved surface as described above. On the other hand, the rubber 30 is joined to the front surface 10a of the heat flux sensor 10, the surface of the rubber 30 being in contact with the inner surface of a curved bearing 41. The rubber 30 and the bearing 41 are not in contact with each other.

As shown in Fig. 7B, when the bearing 41 vibrates in the direction along the circumferential direction (the arrow direction in the drawing) of the rotation shaft 21, the rubber 30 and the front surface protection member 110 deform, and friction occurs between the rubber 30 and the bearing 41 to generate heat like the first embodiment. Accordingly, when a change occurs from the non-applied state in which no vibration is applied to the applied state in which a vibration is applied, a change occurs in the heat flux in the direction from the rubber 30 and the front surface protection member 110 to the rotation shaft 21.

Accordingly, also in this embodiment, like in the first embodiment, it is possible for the heat flux sensor 10 to detect the heat flux from the rubber 30 and the front surface protection member 110 when a vibration is applied to the vibration detecting section 1, and for the control section 2 to detect the vibration energy by calculating the vibration energy based on the sensor signal of the heat flux sensor 10.

### (Third Embodiment)

The first and second embodiments are such that the vibration detecting section 1 detects a vibration in the direction along the surface direction of the heat flux sensor 10, while this embodiment is such that the vibration detecting section 1 detects a vibration in the direction perpendicular to the surface direction of the heat flux sensor 10.

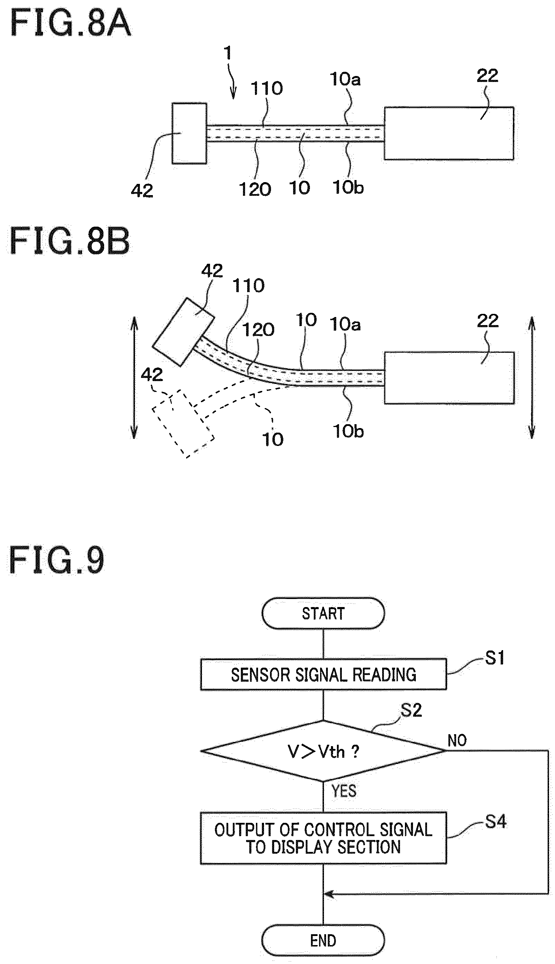

As shown in Fig. 8A, the vibration detecting section 1 of this embodiment has a structure including the heat flux sensor 10, a support body 22 which supports one end in the surface direction of the heat flux sensor 10, and a weight 42 provided in the other end opposite to the one end in the surface direction of the heat flux sensor 10. The structure of the heat flux sensor 10 is the same as that of the first embodiment.

As shown in Fig. 8B, when the support body 22 vibrates in the direction perpendicular to the surface direction of the heat flux sensor 10 (the arrow direction in the drawing), the heat flux sensor 10 vibrates together with the weight 42, and deforms such that one of the front surface 10a and the back surface 10b of the heat flux sensor 10 becomes a convex surface and the other becomes a concave surface. At this time, one of the front surface protection member 110 and the back surface protection member 120, which becomes the concave surface is subjected to a compressive deformation, and the other one which becomes the convex surface is subjected to a tensile deformation. Since the compressive deformed one generates heat, there occurs a temperature difference between the front surface protection member 110 and the back surface protection member 120. That is, there occurs a heat flux in the direction from the concave surface to the convex surface between the front surface protection member 110 and the back surface protection member 120. The direction of the heat flux is switched each time the convex surface and the concave surface are exchanged. Accordingly, in this embodiment, one of the front surface protection member 110 and the back surface protection member 120 constitutes a heat generation member disposed on one surface of the detection element, and the other of the front surface protection member 110 and the back surface protection member 120 constitutes a protection member disposed on the other surface of the detection element.

Accordingly, also according to this embodiment, the vibration energy can be calculated like the first embodiment.

Although the weight 42 is provided in the heat flux sensor 10 in this embodiment, the weight 42 may be omitted if the heat flux sensor 10 can vibrate by the vibration of the support body 22. Although any support member for supporting the heat flux sensor 10 is not provided in the front surface 10a or the back surface 10b of the heat flux sensor 10 in this embodiment, a support member may be provided in at least one of the front surface 10a and the back surface 10b to reinforce the heat flux sensor 10. In this case, since the support member generates heat when subjected to compressive deformation, the support member constitutes a heat generation member. For example, when the support member is provided in the back surface 10b of the heat flux sensor 10, the back surface protection member 120 and the support member constitute a heat generation member disposed on one surface of the detection element, and the front surface protection member 110 constitutes a protection member disposed on the other surface of the detection element.

### (Other Embodiments)

The present invention is not limited to the above described embodiments, but appropriate modifications can be made as described below within the scope described in the claims.

(1) Although the above described respective embodiments detect the vibration energy as data regarding a vibration, they may be modified to detect presence or absence of a vibration. In this case, the control section 2 performs the control process shown in Fig. 9. This control process is the same as the control process shown in Fig. 6 from which step S3 is omitted. That is, the control section 2 proceeds to step S4 if an affirmative determination (YES) is made in step S2, to output a control signal to indicate that a vibration is being detected to the display section. As a result, it is indicated that a vibration is being detected in the display section.
(2) Although it has been explained that the control section 2 performs the detection process of data regarding vibration based on the electromotive voltage (voltage value) occurred in the heat flux sensor 10 in the above described embodiments, the detection process may be performed based on a current value instead of the voltage value. In short, the control section 2 can perform the detection process based on the electromotive force occurred in the heat flux sensor 10.
(3) In the above described embodiments, although the metals forming the first and second inter-layer connection members 130 and 140 are a Bi-Sb-Te alloy and a Bi-Te alloy, respectively, they may be other alloys.
   In the above described embodiments, both the metals forming the first and second inter-layer connection members 130 and 140 are sintered alloys which are solid-phase sintered, however, only one of them may be a sintered alloy which is solid-phase sintered. This makes it possible to increase the electromotive force to thereby increase the sensitivity of the heat flux sensor 10 compared to the case in which neither of the metals forming the first and second inter-layer connection members 130 and 140 is a sintered alloy which is solid-phase sintered.
(4) In the first and second embodiments, although the rubber 30 is used as a heat generation member, a thermoplastic resin or a thermosetting resin may be used instead of the rubber 30. Examples of the thermoplastic resin include polyethylene terephthalate (PET) resin, polyethylenenaphthalate (PEN) resin, polyphenylene sulfide (PPS) resin, polyphenylene ether (PPE) resin, PEEK, PEI and LCP. Examples of the thermosetting resin include epoxy resin, phenol resin and polyimide resin.
(5) The above described embodiments are not mutually exclusive to one another, but may be combined excluding cases which are apparently impossible. It is needless to say that the constituent elements constituting each embodiment are not necessarily indispensable elements unless they are specified to be indispensable elements, or clearly indispensable elements in principle.

### (Reference Example 1)

In this reference example, an accelerator detector using the heat flux sensor is explained.

This reference example relates to an acceleration detector that includes:
a detection element having a structure in which an insulation base material is formed with first and second via holes penetrating therethrough in a thickness direction, first and second inter-layer connection members formed of different metals are embedded in the first and second via holes, and the first and second inter-layer connection members are connected in series alternately;
a heat generation member disposed on one surface of the detection element;
a protection member disposed on other surface of the detection element; wherein
at least one of the metals forming the first and second inter-layer connection members is a sintered alloy sintered in a state in which metal atoms maintain a crystal structure thereof,
the heat generation member generates heat when subjected to at least one of deformation and friction by being applied with an acceleration,
the detection element detects a heat flux between the heat generation member and the protection member by an electromotive force occurring in the first and second inter-layer connection members which are series-connected alternately, and
the acceleration detector further includes a detection processing means which performs a detection process of data regarding acceleration based on the electromotive force occurring in the detection element.

As a structure of the acceleration detector, the structure of the vibration detector of Fig. 1 explained in the first embodiment can be adopted for example. In this case, the acceleration detector includes the vibration detecting section 1 and the control section 2 as shown in Fig. 1. The vibration detecting section 1 and the control section 2 are the same in structure as the vibration detecting section 1 and the control section 2 of the first embodiment, respectively.

The control section 2 is a detection processing means for performing a detection process of data regarding vibration based on a detection result of the heat flux sensor 10. For example, the control section 2 detects an acceleration by performing a process to calculate the acceleration using the control signal (electromotive voltage) of the heat flux sensor 10 and a correlation between the electromotive voltage and the acceleration. The specific detection process is the same as the control process of Fig. 6 explained in the first embodiment. However, in the explanation of the control process of Fig. 6, vibration is replaced by acceleration. For example, "VIBRATION ENERGY CALCULATION" in step S3 of Fig. 6 is replaced by "ACCELERATION CALCULATION".

When a one-way acceleration of the arrow in Fig. 1 is applied to the weight 40, the weight 40 deforms as a result of which the rubber 30 and the front surface protection member 110 deform, causing heat to be generated. Accordingly, when an acceleration is applied to the vibration detecting section 1 from the outside, the temperature difference between the rubber 30 and the front surface protection member 110 on the front surface 10a of the heat flux sensor 10 and the fixing base 20 on the back surface 10b of the heat flux sensor 10 changes from that before the acceleration is applied. That is, a change occurs in the heat flux in the direction from the rubber 30 and the front surface protection member 110 toward the fixing base 20. At this time, there is a relationship that the heat flux from the rubber 30 and the front surface protection member 110 increases or decreases in accordance with the magnitude of a vibration applied.

Accordingly, the heat flux from the rubber 30 and the front surface protection member 110 when an acceleration is applied to the weight 40 is detected. Further, the acceleration is detected by the control section 2 based on the detection result of the heat flux sensor 10. A correlation between the sensor signal (electromotive voltage) and acceleration was obtained beforehand so that an acceleration can be detected from the sensor signal using this correlation.

Incidentally, an acceleration can be detected also when the same structure as the vibration detector explained in the second, third or other embodiments is employed for the same reason as described in the foregoing.

As described above, the presence or absence of an acceleration and data regarding the acceleration such as its magnitude can be detected by the structure of the acceleration detector, which includes the heat generation member which generates heat when applied with an acceleration to be subjected to at least one of deformation and friction, the detection element which detects the heat flux from this heat generation member, and the detection processing means for performing detection process of the data regarding the acceleration based on a detection result of this detection element.

According to such an acceleration detector, it is possible to solve a problem similar to the problem to be solved by the invention of the vibration detector described in the foregoing. Further, in this embodiment, since the sensitive heat flux sensor 10 is used like in the first embodiment, a heat flux occurring when the member is applied with an acceleration can be detected, and the data regarding the acceleration can be obtained from this detection result.

(Reference Example 2)

In this reference example, a pressure detector using the heat flux sensor is explained.

This reference example relates to a pressure detector that includes:
a detection element having a structure in which an insulation base material is formed with first and second via holes penetrating therethrough in a thickness direction, first and second inter-layer connection members formed of different metals are embedded in the first and second via holes, and the first and second inter-layer connection members are connected in series alternately;
a heat generation member disposed on one surface of the detection element;
a protection member disposed on other surface of the detection element; wherein
at least one of the metals forming the first and second inter-layer connection members is a sintered alloy sintered in a state in which metal atoms maintain a crystal structure thereof,
the heat generation member generates heat when applied with a pressure to be subjected to deformation,
the detection element detects a heat flux between the heat generation member and the protection member by an electromotive force occurring in the first and second inter-layer connection members series-connected alternately, and
the pressure detector further includes a detection processing means which performs detection process of data regarding the vibration based on the electromotive force occurring in the detection element.

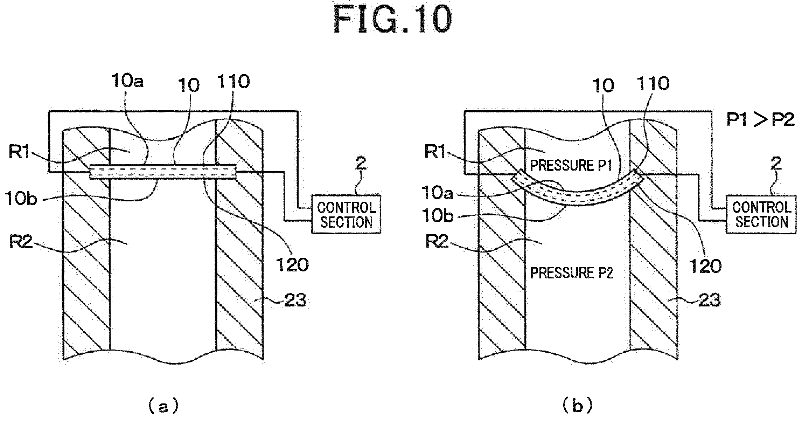

As shown in Fig. 10 (a), this pressure detector includes the heat flux sensor 10 and the control section 2.

The heat flux sensor 10, which is the same in structure as the heat flux sensor 10 of the first embodiment, is such that the insulation base material 100, the front surface protection member 110 and the back surface protection member 120 are integrated, and the first and second inter-layer connection members 130 and 140 are series-connected alternately therein as shown in Figs. 2 to 4. The structural part of the heat flux sensor 10, in which the first and second inter-layer connection members 130 and 140 are series-connected alternately, forms the detection element for detecting the heat flux from the front surface protection member 110 or the back surface protection member 120.

The heat flux sensor 10 is provided within a case 23 so as to partition the inside of the case 23 into a first space R1 and a second space R2.

The control section 2 is a detection processing means for performing a data detection process of data regarding pressure based on a detection result of the heat flux sensor 10. The control section 2 has the same structure as the control section 2 of the first embodiment. For example, the control section 2 detects a difference between the pressure of the first space R1 and the pressure of the second space R2 by performing a calculation process for calculating the pressure difference using the sensor signal (electromotive voltage) of the heat flux sensor 10 and a correlation between the electromotive voltage and the pressure difference. The specific detection process is the same as the control process of Fig. 6 explained in the first embodiment. However, in the explanation of the control process of Fig. 6, vibration is replaced by pressure difference. For example, "VIBRATION ENERGY CALCULATION" in step S3 in Fig. 6 is replaced by "PRESSURE DIFFERENCE CALCULATION".

As shown in Fig. 10(b), when a pressure difference occurs between the first space R1 and the second space R2, deformation occurs such that one of the front surface 10a and the back surface 10b of the heat flux sensor 10 becomes a convex surface, and the other becomes a concave surface. For example, if the pressure P1 of the first space R1 is greater than the pressure P2 of the second space R2, the front surface 10a becomes a concave surface, and the back surface 10b becomes a concave surface. Accordingly, like the third embodiment, there occurs a heat flux in the direction from the concave surface to the convex surface between the front surface protection member 110 and the back surface protection member 120. As described above, in this reference example, one of the front surface protection member 110 and the back surface protection member 120 constitutes a heat generation member disposed on one surface of the detection element, and the other of the front surface protection member 110 and the back surface protection member 120 constitutes a protection member disposed on the other surface of the detection element.

At this time, the heat flux increases or decreases in accordance with the magnitude of the pressure difference. Accordingly, it is possible to obtain data regarding the pressure based on the detection result of the heat flux sensor 10. Incidentally, if one of the pressures of the first and second spaces R1 and R2 is set as a reference pressure, it is possible to detect the other of the pressures of the first and second spaces R1 and R2 from the pressure difference.

As described above, the data regarding a pressure such as the pressure difference, the absolute pressure and so on can be detected by the structure of the pressure detector, which includes the heat generation member which generates heat when applied with a pressure to be subjected to deformation, the detection element which detects the heat flux from this heat generation member, and the detection processing means for performing a detection process of the data regarding the pressure.

Incidentally, in the example of the drawing, although the inside of the case 23 is partitioned into the first space R1 and the second space R2 by the heat flux sensor 10 itself, the heat flux sensor 10 may be fitted to the surface of a partition member for partitioning the inside of the case 23. In this case, since the partition member generates heat when subjected to deformation by pressure, also the partition member constitutes a heat generation member. For example, when the partition member is disposed on the back surface 10b of the heat flux sensor 10, the back surface protection member 120 and the partition member constitute a heat generation member disposed on one surface of the detection element, and the front surface protection member 110 constitutes a protection member disposed on the other surface of the detection element.

In this reference example, since the sensitive heat flux sensor 10 is used like in the first embodiment, a heat flux occurring when the member is applied with a pressure can be detected, and the data regarding the pressure can be obtained from this detection result. According to such a pressure detector, it is possible to solve a problem similar to the problem to be solved by the invention of the vibration detector described above.

### (Reference Example 3)

In this reference example, a humidity detector using the heat flux sensor is explained.

This reference example relates to a humidity detector that includes:
a detection element having a structure in which an insulation base material is formed with first and second via holes penetrating therethrough in a thickness direction, first and second inter-layer connection members formed of different metals are embedded in the first and second via holes, and the first and second inter-layer connection members are connected in series alternately;
a water absorbent member disposed on one surface of the detection element;
a protection member disposed on other surface of the detection element; wherein
at least one of the metals forming the first and second inter-layer connection members is a sintered alloy sintered in a state in which metal atoms maintain a crystal structure thereof,
the water absorbent member absorbs water and decreases in temperature due to evaporation of the water by an amount in accordance with humidity of environment in which the water absorbent member is located,
the detection element detects a heat flux between the water absorbent member and the protection member by an electromotive force occurring in the first and second inter-layer connection members series-connected alternately, and
the humidity detector further includes a detection processing means which performs detection process of data regarding the vibration based on the electromotive force generated in the detection element.

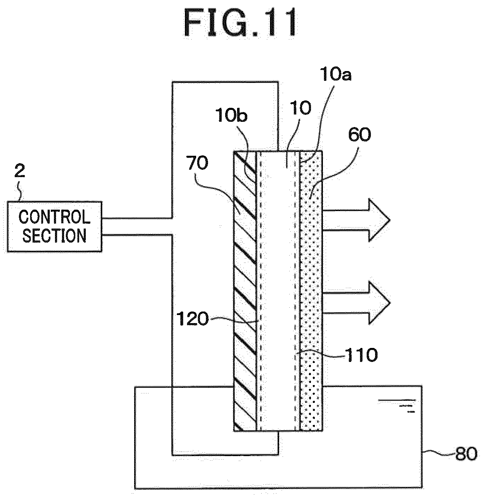

As shown in Fig. 11 this humidity detector includes the heat flux sensor 10, the control section 2, a water absorbent layer 60 provided on the front surface 10a of the heat flux sensor 10, a water repellent layer 70 provided on the back surface 10b of the heat flux sensor 10, and a container 80 for storing water absorbed by the water absorbent layer.

The heat flux sensor 10 detects the heat flux in the direction from the water repellent layer 70 to the water absorbent layer 60. The heat flux sensor 10, which is the same in structure as the heat flux sensor 10 of the first embodiment, is such that the insulation base material 100, the front surface protection member 110 and the back surface protection member 120 are integrated, and the first and second inter-layer connection members 130 and 140 are series-connected alternately therein as shown in Figs. 2 to 4. The structural part of the heat flux sensor 10, in which the first and second inter-layer connection members 130 and 140 are series-connected alternately, forms a detection element for detecting the heat flux between the water absorbent layer 60 and the back surface protection member 120.

The water absorbent layer 60, which is a layer constituted of the water adsorbent member for absorbing the water inside container 80, is made of polyester fiber, for example. On the other hand, the water repellent layer 70, which is a layer which does not adsorb water, is made of fluoro resin, for example. Part of the heat flux sensor 10 is located inside the container 80 so that the water absorbent layer 60 can absorb the water inside the container 80.

The control section 2 is a detection processing means for performing a data detection process of data regarding humidity based on a detection result of the heat flux sensor 10. The control section 2 has the same structure as the control section 2 of the first embodiment. For example, the control section 2 calculates an evaporation amount using the sensor signal (electromotive voltage) of the heat flux sensor 10 and the correlation between the electromotive voltage and the evaporation amount, and detects humidity by performing a process for calculating humidity from change of the evaporation amount, and so on. The specific detection process is the same as the control process of Fig. 6 explained in the first embodiment. However, in the explanation of the control process of Fig. 6, vibration is replaced by humidity. For example, "VIBRATION ENERGY CALCULATION" in step S3 in Fig. 6 is replaced by "HUMIDITY CALCULATION".

The water within the water absorbent layer 60 vaporizes in accordance with the humidity of the environment of the water absorbent layer 60. At this time, the temperature of the water absorbent layer 60 decreases by the evaporation heat. On the other hand, since the water repellent layer 70 does not contain water, such a phenomenon does not occur. Accordingly, a temperature difference occurs between the water repellent layer 70 and the water absorbent layer 60, causing a heat flux in the direction from the water repellent layer 70 to the water absorbent layer 60. At this time, if the humidity of the environment changes, since the evaporation amount of the water within the water absorbent layer 60 changes, the heat flux in the direction from the water repellent layer 70 to the water absorbent layer 60 changes too. Accordingly, the humidity can be detected based on the detected heat flux by detecting the heat flux in the direction from the water repellent layer 70 to the water absorbent layer 60.

Incidentally, although this reference example is provided with the water repellent layer 70, the water repellent layer may be omitted. In this case, when the water within the water absorbent layer 60 vaporizes, there occurs a heat flux in the direction from the back surface protection member 120 to the water absorbent layer 60. In this example, although the container 80 is used, the container 80 may be omitted, if it is possible to supply water to the water absorbent layer 60. As means for supplying water to the water absorbent layer 60, means for cooling the air using a Peltier device to condense moisture in the air can be exemplified.

As described above, data regarding humidity can be obtained by the structure of the humidity detector, which includes the water absorbent layer which absorbs water and from which the water evaporates by an amount in accordance with the humidity of the environment, the detection element for detecting the heat flux toward the water absorbent member, and the detection process means for performing the detection process of data regarding the humidity.

In this example, since the sensitive heat flux sensor 10 is used like in the first embodiment, the heat flux occurring when the water within the absorbent layer 60 evaporates can be detected, and data regarding the humidity can be obtained from this detection result.

### Explanation of Symbols

- 2: control section
- 10: heat flux sensor
- 30: rubber (elastic member)
- 100: insulation base material
- 101, 102: first and second via holes
- 130, 140: first and second inter-layer connection members

## Claims

1. A vibration detector comprising:
a detection element having a structure in which an insulation base material (100) is formed with first and second via holes (101, 102) penetrating therethrough in a thickness direction, first and second inter-layer connection members (130, 140) formed of different metals are embedded in the first and second via holes, and the first and second inter-layer connection members are connected in series alternately;
a heat generation member (30, 110) disposed on one surface of the detection element; and
a protection member (120) disposed on the other surface of the detection element; wherein
at least one of the metals forming the first and second inter-layer connection members is a sintered alloy sintered in a state in which metal atoms maintain a crystal structure thereof,
the heat generation member generates heat when subjected to at least one of deformation and friction by a vibration from the outside,
the detection element detects a heat flux between the heat generation member and the protection member by an electromotive force occurring in the first and second inter-layer connection members which are series-connected alternately, and
the vibration detector further comprises a detection processing means (2) which performs a detection process of data regarding vibration based on the electromotive force occurring in the detection element.

2. The vibration detector according to claim 1, further comprising a front surface protection member (110) made of a thermoplastic resin formed with front surface patterns (111) and disposed on a front surface (100a) of the insulation base material, and a back surface protection member (120) made of a thermoplastic resin formed with back surface patterns (121) and disposed on a back surface (100b) opposite to the front surface of the insulation base material,
the back surface protection member, the detection element and the front surface protection member being integrated,
one of the front surface protection member (110) and the back surface protection member (120) constituting the heat generation member, the other of the front surface protection member (110) and the back surface protection member (120) constituting the protection member.

3. The vibration detector according to claim 1, further comprising a front surface protection member (110) made of a thermoplastic resin formed with front surface patterns (111) and disposed on a front surface (100a) of the insulation base material, and a back surface protection member (120) made of a thermoplastic resin formed with back surface patterns (121) and disposed on a back surface (100b) opposite to the front surface of the insulation base material,
the back surface protection member, the detection element and the front surface protection member being integrated,
the vibration detector further comprising an elastic member (30) disposed on a front surface of the front surface protection member,
the elastic member and the front surface protection member constituting the heat generation member, the back surface protection member constituting the protection member.
